# EUROPEAN PATENT APPLICATION

(11) **EP 4 718 867 A1**
(43) Date of publication of application: **01.04.2026**
(21) Application number: 24202739.9
(22) Date of filing: 26.09.2024
(51) Int. Cl.: H04R 3/00, H04R 3/04

(54) **A MICROPHONE FOR CAPTURING SOUND**

(71) Applicant: DPA Microphones A/S, 2980 Kokkedal (DK)
(72) Inventor: MEYER, Rasmus Alexander, Kokkedal (DK); TORRAS ROSELL, Antoni, Kokkedal (DK)
(74) Representative: Zacco Denmark A/S

(57) **Abstract**

Disclosed is a microphone for capturing sound. The microphone comprises a capsule configured for receiving a sound input and converting the sound input into an output signal, the output signal comprising an output voltage V_CA, the output voltage V_CA having a first non-linearity at least at sound pressure levels (SPLs) above a first threshold. The microphone comprises a pre-amplifier configured for receiving the output signal from the capsule and generating an output voltage V_PA, the output voltage V_PA having a second non-linearity for at least a first input signal level. The microphone is configured for providing that the capsule and the pre-amplifier generate similar amounts of the first non-linearity and of the second non-linearity, respectively, and where the first non-linearity and the second non-linearity are in anti-phase to each other, thereby counter-balancing each other and thereby linearizing an output signal V_MI of the microphone.

## Description

### FIELD

The present invention relates to a microphone for capturing sound, where the microphone comprises a capsule and a pre-amplifier.

### BACKGROUND

For high-fidelity microphones, which are used e.g. for recording or measurements of audio, it is a desire to achieve pristine sound quality, also at extremely high sound pressure levels. It is a problem of conventional microphones to achieve good sound quality when the sound pressure level increases.

Thus, there is a need for a microphone which is capable of capturing sound at very high sound pressure levels without distorting it.

### SUMMARY

Disclosed is a microphone for capturing sound. The microphone comprises a capsule configured for receiving a sound input and converting the sound input into an output signal. The output signal comprising an output voltage V_CA. The output voltage V_CA having a first non-linearity at least at sound pressure levels (SPLs) above a first threshold.

The microphone comprises a pre-amplifier configured for receiving the output signal from the capsule and generating an output voltage V_PA. The output voltage V_PA having a second non-linearity for at least a first input signal level.

The microphone is configured for providing that the capsule and the pre-amplifier generate similar amounts of the first non-linearity and of the second non-linearity, respectively, and where the first non-linearity and the second non-linearity are in anti-phase to each other, thereby counter-balancing each other and thereby linearizing an output signal V_MI of the microphone.

The microphone may be a distortion-free microphone. The microphone comprises a capsule configured for receiving a sound input and converting the sound input into an output signal. Thus, the capsule converts sound waves into microphone signals. The output signal comprises an output voltage V_CA. The output voltage V_CA has a first non-linearity at least at sound pressure levels (SPLs) above a first threshold. This may be due to the transduction mechanism of the capsule. When a signal passes from input to output, any change in that signal, i.e., the signal's waveform, can be regarded as distortion. Nonlinear distortion may refer to the case where the output signal comprises new frequency components that were not present in the input signal.

The output voltage V_CA may have a first non-linearity or non-linearities at least at sound pressure levels (SPLs) above a first threshold.

Nonlinearity can be defined as a property of mathematical functions or data that cannot be graphed on straight lines, and systems whose output(s) are not directly proportional to their input(s).

Linearity can be defined as a property of a function or mapping, where a linear function maps the real line to a line in a plane. Linearity of a mapping is closely related to proportionality. Generalized for functions in more than one dimension, linearity means the property of a function of being compatible with addition and scaling, also known as the superposition principle.

Thus, from a mathematical perspective, a linear function can lead to an output that may always be proportional to the input, scaled up or down, plus a certain offset, where an offset which is zero is also included.

From an acoustical point of view, it may be slightly different, since offset (DC components) may not contain any acoustical information. So, in acoustics, a linear system may provide an output where each spectral component of the output signal is proportional to the same spectral component of the input signal with a certain phase shift, typically also referred to as delay, since real systems may always be causal. This means that a linear system cannot or may not generate new spectral components.

The sound pressure levels may be so-called high sound pressure levels (SPLs). Thus, the non-linearity of the microphone capsule may only be significant at high sound pressure levels, and the non-linearity may arise from the asymmetric motion of the membrane. In the case of a condenser microphone, this asymmetric motion is caused by the electric field generated inside the capsule to accumulate charges at the membrane that will then be used to generate the output signal of the capsule. If the microphone is a condenser microphone, the membrane may have a position in front of a back plate or back electrode. The space between the two may be in the range of 20-50 µm. When placing the microphone in a high-SPL situation, there may be a limit to the excursion of the membrane, at least when pushed in the direction of the back plate. Also, the electric field generated inside the capsule may no longer be constant for large excursions of the membrane, at high sound pressure levels, because the electric field may be stronger when the membrane is moving towards the back-electrode, and weaker when the membrane moves away from the back-electrode.

The microphone is a transducer that converts sound into an electrical signal. The microphone may be used in many applications, but most relevant for the type of microphone described here, is live and recorded audio engineering, sound recording, motion picture production, radio and television broadcasting. The microphone may be of different types, which employ different methods to convert the air pressure variations of a sound wave to an electrical signal. The microphone may be a dynamic microphone, which uses a coil of wire suspended in a magnetic field; or the microphone may be an electret or condenser microphone, which uses the vibrating membrane or diaphragm as a capacitor plate. The microphone capsule is connected to a pre-amplifier before the signal can be recorded or reproduced.

The microphone comprises a pre-amplifier configured for receiving the output signal from the capsule and generating an output voltage V_PA. The output signal V_PA is provided to a next element in the measurement/recording chain of the microphone or the other equipment. The pre-amplifier is coupled to the capsule. The output voltage V_PA has a second non-linearity for at least a first input signal level. The first input signal level may be defined as an input signal with large amplitudes, and the second non-linearity of the output voltage V_PA may be due to the non-linear behavior of the electrical components used in the pre-amplifier circuit. If the input signal from the capsule is not high enough, i.e. no large amplitudes, then there may not be non-linearities generated by the pre-amplifier. Thus other levels of input signals, e.g. with low amplitudes, may not provide a non-linearity.

The output voltage V_PA may have a second non-linearity or non-linearities for at least a first input signal level.

The microphone is configured for providing that the capsule and the pre-amplifier generate similar amounts of the first non-linearity and of the second non-linearity, respectively. Thus the amount of the first non-linearity of the capsule and the amount of the second non-linearity of the pre-amplifier are similar, such as substantially similar, such as corresponding to each other, such as being approximately the same or being approximately identical.

The first non-linearity of the capsule and the second non-linearity of the pre-amplifier are in anti-phase to each other. For sinusoidal signals, when the phase difference φ(t) is 180° (pi radians), the phases are opposite, and the signals are in antiphase. Then the signals have opposite signs.

The non-linear behavior of the microphone capsule is in opposite phase of the non-linear behavior of the pre-amplifier in this system.

Because the first non-linearity and the second non-linearity are similar, e.g the same, but in anti-phase to each, the non-linearities counter-balance each other, and the output signal V_MI of the microphone is thereby linearized.

Thus, the non-linearity of the pre-amplifier (nl_PA) is similar, e.g. equal, but in opposite phase to the microphone capsule non-linearity (nl_CA), and this will result in a cancellation of non-linearities that yields a very low total harmonic distortion (THD) of the system output, V_MI, up to the clipping point of the system.

Thus, the capsule and the pre-amplifier generate non-linearities respectively when the input signal level is large. The capsule and the pre-amplifier are designed for compensating and counter-balancing each other's non-linearities, thereby linearizing the output voltage of the microphone.

This is an advantage of the new microphone compared to conventional microphone design, because the new microphone makes it possible to achieve pristine sound quality at extremely high sound pressure levels. The output of a conventional microphone starts getting contaminated with acousto-mechanical nonlinearities from the capsule and electrical non-linearities from the preamplifier when increasing the sound pressure levels at which the microphone is exposed to. Traditionally, manufacturers tackle this problem by trying to linearize the non-linear behaviour of the capsule and the preamplifier separately. However, there is a limit to how much one can linearize the capsule before compromising other important parameters of the microphone such as sensitivity and frequency response, and to how much one can linearize the preamplifier before complexity, size and cost of the electronics impact the final product design. The new microphone solves this problem by avoiding linearization of the microphone's subsystems, i.e. the capsule and the preamplifier, and designing them to act together in counterbalancing each other's non-linearities. In this way, the new microphone surpasses the classical engineering strategy of minimizing non-linearities and is capable of capturing perfectly undistorted sound at very large sound pressure levels.

In some embodiments, the counter-balancing effect of the non-linearities between the capsule and the preamplifier is relevant for sound pressure levels (SPLs) above the first threshold, where the first threshold is high SPLs, and where the SPLs are between 110 dB SPL - 160 dB SPL. Thus, the sound pressure levels may be so-called high sound pressure levels (SPLs), and the non-linearity of the microphone capsule may only be significant at high sound pressure levels. Thus, the output voltage V_CA has a first non-linearity at least at sound pressure levels (SPLs) above a first threshold. The first threshold may thus be sound pressure levels (SPLs) above about 110 dB SPL.

The sound pressure levels may be between about 110 dB SPL -160 dB SPL, such as between about 115 dB SPL -160 dB SPL, such as between about 120 dB SPL -160 dB SPL, such as between about 125 dB SPL -160 dB SPL, such as between about 130 dB SPL -160 dB SPL, such as between about 135 dB SPL -160 dB SPL, such as between about 140 dB SPL -160 dB SPL.

The sound pressure levels may be between about 110 dB SPL -160 dB SPL, such as between about 110 dB SPL -155 dB SPL, such as between about 110 dB SPL -150 dB SPL, such as between about 110 dB SPL -145 dB SPL, such as between about 110 dB SPL -140 dB SPL, such as between about 110 dB SPL -135 dB SPL, such as between about 110 dB SPL -130 dB SPL.

The output voltage V_CA may also have a first non-linearity at sound pressure levels (SPLs) below a first threshold.

In some embodiments, the first input signal level comprises input signals with amplitudes above a second threshold. Thus, the first input signal level may be defined as an input signal with large amplitudes. Thus other levels of input signals, e.g. with low amplitudes, may or may not provide a non-linearity of the signal.

In some embodiments, the microphone is a condenser microphone, and the capsule comprises a membrane and a back-electrode.

In some embodiments, the microphone is an electret microphone, and the capsule comprises a membrane and a back-electrode.

In some embodiments, the microphone is a dynamic microphone, and the capsule comprises a membrane and a magnet.

A condenser microphone may also be called a capacitor microphone or electrostatic microphone. The membrane or diaphragm may act as one plate of a capacitor, and audio vibrations produce changes in the distance between the plates. Because the capacitance of the plates is inversely proportional to the distance between them, the vibrations produce changes in capacitance. These changes in capacitance are used to measure the audio signal.

An electret microphone is a microphone whose membrane or diaphragm forms a capacitor (a condenser) that incorporates an electret. The electret may comprise a permanent electric dipole which provides a constant charge on the capacitor. Sound waves move the membrane, changing the capacitance C, which produces a corresponding voltage change across the capacitor. The electret's constant charge may eliminate the need for a polarizing power supply that may be required for non-electret condenser microphones, though a preamplifier may be incorporated to boost the audio voltage signal. The preamplifier may require a small amount of power, and is frequently phantom powered in sound reinforcement and studio applications. An electret is a stable dielectric material with permanently-embedded electric charges, and it is persistent due to its high resistance and chemical stability.

A dynamic microphone comprises a small movable induction coil, positioned in the magnetic field of a permanent magnet, and being attached to the membrane or diaphragm. When sound impinges the microphone, the sound wave moves the diaphragm. When the diaphragm vibrates, the coil moves in the magnetic field, producing a varying voltage across the coil through electromagnetic induction.

The assembly of fixed and movable plates is called an element or capsule. All the microphone types mentioned above may be high-fidelity recording microphones. The microphones produce a high-quality audio signal and are being used in laboratory and recording studio applications. The advantage of the microphones is the ability to capture a broad frequency range of sounds compared to other microphone types that struggle to do that and thereby deteriorate the quality of the output signal. The microphones require a power source, and the microphones may be connected to the power source which can be provided either via microphone inputs on equipment as phantom power or from a small battery or another power source. Power may be needed for establishing the capacitor plate voltage, e.g. for the condenser microphone, and may also be needed to power the microphone electronics. Depending on the method of extracting the audio signal from the transducer of the microphone, the microphones may be DC-biased microphones, or radio frequency (RF) etc..

In some embodiments, the microphone is connected to a power source, and wherein the power source is connected to a resistive load (RL). The preamplifier of the microphone may be connected to the power source. The power source may be a positive power supply Vsupply. A resistor Rc may be connected as load, i.e resistive load RL, to the positive power supply Vsupply.

In some embodiments, the pre-amplifier comprises an active element Q1.

In some embodiments, the active element Q1 is a transistor.

In some embodiments, the transistor is a junction field-effect transistor (JFET) or a metal-oxide-semiconductor field-effect transistor (MOSFET) or a bipolar junction transistor (BJT), such as an NPN BJT.

It is an advantage that the active element Q1 being a transistor can be a small component and standard component, which thus only takes up little space in the microphone, and may be cheap and easy to purchase. If the active element Q1 is small, then the microphone can be made small, which is an advantage for some purposes. For other purposes, e.g. pencil microphones from DPA Microphones, the active element Q1 and thus the microphone may not have to be small.

The transistor is a semiconductor device which can be used to amplify or switch electrical signals and power. It is composed of semiconductor material, and may have two, three or more terminals for connection to an electronic circuit. A voltage or current applied to one pair of the transistor's terminals controls the current through another pair of terminals. Because the controlled (output) power can be higher than the controlling (input) power, the transistor can amplify the signal.

There may be different advantages of using the different transistors, such as junction field-effect transistor (JFET) or a metal-oxide-semiconductor field-effect transistor (MOSFET) or a bipolar junction transistor (BJT), such as an NPN BJT. The different transistors may be advantageous to use with different capsules, e.g. condenser, electret, dynamic, and with electrical circuit designs, such as with different power supply etc.

An electrical circuit may comprise a resistor (RC) connected as load to a positive power supply (Vsupply). Two resistors (RB1 and RB2) may establish a bias voltage for the base of the active element Q1 and a resistor (RE) acting as local feedback for the active element Q1. Combined with the DC-parameters of the active element Q1, the resistors RC, RB1, RB2 and RE may establish an operating point (q) for the active element Q1. The microphone capsule may connect between RB1 and RB2 to the base of Q1 and ground.

The active element Q1 may be a bipolar junction transistor, such as NPN BJT, which has, by its manufacturing processes and technology, several intrinsic nonlinearities build in. Relevant for this invention is the ohmic nonlinearity being the varying nature of symmetry in the current-voltage, I_{C}-V_{CE}, transfer characteristic for different current, I_{B} .

For a given operating point (q) on a loadline (R_{L}), an equal positive (*i_{Bmax}*) and negative (*i_{Bmin}*) base current change will not yield an equal positive (*i_{Cmax}*) and negative *(i_{Cmin})* collector current change, resulting in a distorted output-voltage (V_PA) generated across the loadline (R_{L}).

The microphone capsule may be exemplified as an electret microphone capsule, which can be illustrated as a charged capacitor with at capacitance (C_{MIC}) that varies when the membrane is moving caused by a sound pressure level (SPL), creating a varying voltage V_CA to the SPL. The electret microphone can be seen as a voltage generator in series with a capacitor. When connecting an electret microphone capsule to the base of the active element Q1 of the common emitter voltage amplifying topology pre-amplifier, the varying voltage output V_CA generates a varying current (iᵢₙ) through the resistor Rᵢₙ of the pre-amplifier. A fraction of iᵢₙ is modulating the base current (I_{b}) of the active element Q1 related to the varying SPL.

The microphone capsule may for example be an electret microphone capsule, and it has from manufacturing build in non-linearities (nl_CA). This creates a non-linear output voltage V_CA compared to the sound pressure input. The pre-amplifier has by topology also build in non-linearities (nl_PA).

The system may have non-linearities and feedback. The non-linear behavior of the microphone capsule is in opposite phase of the non-linear behavior of the pre-amplifier in this system.

By selecting a DC operating point (q) of the active element Q1, given by its transfer characteristics, the choice of loadline (R_{L}), the amount of local feedback (K), resulting in an equal non-linearity (nl_PA) of the pre-amplifier 6, but in opposite phase to the microphone capsule non-linearity (nl_CA), will result in a cancellation of non-linearities that yields a very low total harmonic distortion (THD) figure of the system output (V_MI) up to the clipping point of the system.

The loop gain T = A*K*nl_PA, where, A is the gain or amplification of the active element Q1, and K is the local feedback.

The voltage output V_PA of the pre-amplifier is thus the voltage output V_CA of the capsule multiplied by the loop gain T, i.e. V_PA = V_CA*T.

In some embodiments, the pre-amplifier comprises a bias circuit and a feedback circuit coupled together with the active element Q1. Thus, both the bias circuit and the feedback circuit may be coupled to the active element Q1.

In some embodiments, the bias circuit is coupled between the capsule and the active element Q1 of the pre-amplifier.

In some embodiments, the bias circuit and the feedback circuit of the pre-amplifier are adjusted for counter-balancing the first non-linearity of the capsule.

In some embodiments, the resistive load (RL) is coupled to the pre-amplifier.

In some embodiments, the resistive load (RL) is coupled to the active element Q1 of the pre-amplifier.

In some embodiments, the resistive load (RL) is coupled to the pre-amplifier via a feedback loop, the feedback loop comprising the feedback circuit of the pre-amplifier.

In some embodiments, the active element Q1 of the pre-amplifier is connected to a resistor RC, where the resistor RC is connected to a positive power supply (Vsupp), and where a resistor RB1 and a resistor RB2 of the pre-amplifier are configured to establish a bias voltage for a base of the active element Q1 and a resistor RE acting as local feedback for the active element Q1. Furthermore, the resistor RC may be connected as load RL to the positive power supply (Vsupp).

In some embodiments, the capsule is connected between the resistor RB1 and the resistor RB2 to the base of the active element Q1 and ground.

In some embodiments, the active element Q1 is configured for creating a distortion effect of the output voltage V_PA of the pre-amplifier thereby providing the second non-linearity. The active element Q1 may generate or provide the second non-linearity because of intrinsic nonlinearities build in to the active element Q1.

In some embodiments, the distortion effect caused by the active element Q1 provides that the output voltage V_PA of the pre-amplifier is different from what it would have been without the distortion effect, and wherein the distortion effect is more prominent for either positive voltages or negative voltages, thereby providing the second non-linearity.

In some embodiments, the active element Q1 provides that the pre-amplifier provides the second non-linearity due to the resistive load (RL) introducing an amount of distortion.

The active element Q1 may generate or provide the second non-linearity because of intrinsic nonlinearities build in to the active element Q1. The resistive load RL may affect the amount of the second non-linearity.

Thus, the second non-linearity is provided in the voltage output V_PA from the preamplifier at least partly because the amount of distortion is higher with resistive load RL than with the prior art.

In some embodiments, the output voltage V_CA provided by the capsule has larger positive voltages than negative voltages or vice versa, thereby providing the first non-linearity. The output voltage V_CA provided by the capsule will have either larger positive voltages than negative voltages, or larger negative voltages than positive voltages, due to the membrane of the capsule being dragged more towards the back electrode at high sound pressure levels (SPLs), e.g. SPL above the first threshold. This provides the first non-linearity. Whether the positive voltages are larger than the negative voltages, or vice versa, depends on design the capsule. Typically, the back electrode of the capsule will be at the bottom, and the membrane will be at the top, and this will provide larger positive voltages than negative voltages. However, if the capsule is designed with the back electrode at the top and the membrane at the bottom, this would change the polarity of the capsule, and then the negative voltages will be larger than the positive voltages. It may also be an option to change the polarity of the capsule in electret microphones by embedding positives charges to the electret material instead of negative ones.

The first non-linearity of the voltage output V_CA of the capsule is counter-balanced with the second non-linearity of the voltage output V_PA of the pre-amplifier. Therefore, the distortion effect, providing the second non-linearity, caused by the active element Q1 is more prominent for either positive voltages or negative voltages, and whether the pre-amplifier is designed to provide the distortion effect to be more prominent for positive or negative voltages depends on the polarity of the capsule, since the capsule provide that either the positive voltages are larger than the negative voltages, or vice versa, as explained above.

According to an aspect, disclosed is a method in a microphone for capturing sound, the method comprises:
- receiving a sound input and converting the sound input into an output signal, in a capsule of the microphone, the output signal comprising an output voltage V_CA, the output voltage V_CA having a first non-linearity at least at sound pressure levels (SPLs) above a first threshold;
- receiving the output signal from the capsule and generating an output voltage V_PA, in a pre-amplifier of the microphone, the output voltage V_PA having a second non-linearity for at least a first input signal level;
- providing that the capsule and the pre-amplifier generate similar amounts of the first non-linearity and of the second non-linearity, respectively, and where the first non-linearity and the second non-linearity are in anti-phase to each other, thereby counter-balancing each other and thereby linearizing an output signal V_MI of the microphone.

The present invention relates to different aspects including the microphone described above and in the following, and corresponding systems, and device parts, each yielding one or more of the benefits and advantages described in connection with the first mentioned aspect, and each having one or more embodiments corresponding to the embodiments described in connection with the first mentioned aspect and/or disclosed in the appended claims.

### BRIEF DESCRIPTION OF THE DRAWINGS

The above and other features and advantages will become readily apparent to those skilled in the art by the following detailed description of exemplary embodiments thereof with reference to the attached drawings, in which:
Fig. 1 schematically illustrates an exemplary electrical circuit for a microphone.
Fig. 2 schematically illustrates an exemplary current-voltage, I_{C}-V_{CE}, transfer characteristic for different current, I_{B}.
Fig. 3 schematically illustrates an exemplary electrical circuit for a microphone.
Fig. 4 schematically illustrates an exemplary electrical circuit for a microphone.
Fig. 5 schematically illustrates an exemplary electrical circuit for a microphone.
Fig. 6 schematically illustrates an exemplary electrical circuit for a microphone.
Fig. 7a and 7b schematically illustrate exemplary graphs showing the total harmonic distortion (THD) [%] as a function of sound pressure level [dB SPL].
Fig. 8a, 8b and 8c schematically illustrate exemplary output of the pre-amplifier in two situations.

### DETAILED DESCRIPTION

Various embodiments are described hereinafter with reference to the figures. Like reference numerals refer to like elements throughout. Like elements will, thus, not be described in detail with respect to the description of each figure. It should also be noted that the figures are only intended to facilitate the description of the embodiments. They are not intended as an exhaustive description of the claimed invention or as a limitation on the scope of the claimed invention. In addition, an illustrated embodiment needs not have all the aspects or advantages shown. An aspect or an advantage described in conjunction with a particular embodiment is not necessarily limited to that embodiment and can be practiced in any other embodiments even if not so illustrated, or if not so explicitly described.

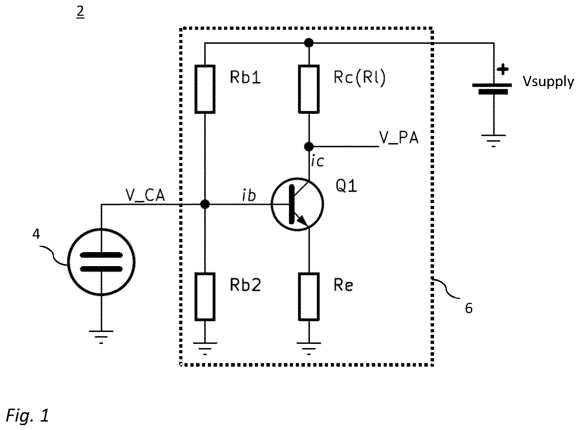

Fig. 1 schematically illustrates an exemplary electrical circuit for a microphone. The microphone 2 is for capturing sound. The microphone 2 comprises a capsule 4 configured for receiving a sound input and converting the sound input into an output signal. The output signal comprising an output voltage V_CA. The output voltage V_CA has a first non-linearity at least at sound pressure levels (SPLs) above a first threshold.

The microphone 2 comprises a pre-amplifier 6 configured for receiving the output signal V_CA from the capsule and generating an output voltage V_PA. The output voltage V_PA has a second non-linearity for at least a first input signal level.

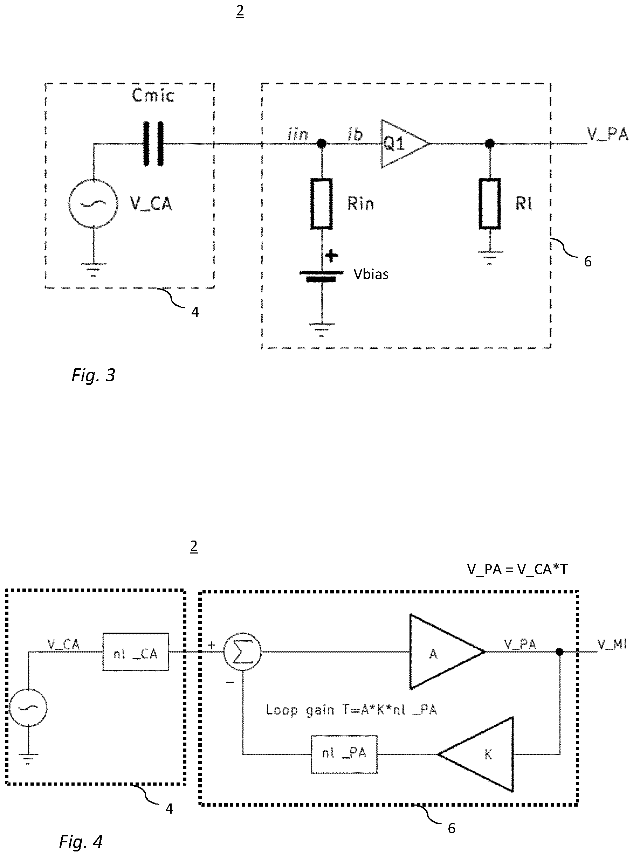

The microphone 2 is configured for providing that the capsule 4 and the pre-amplifier 6 generate similar amounts of the first non-linearity and of the second non-linearity, respectively, and that the first non-linearity and the second non-linearity are in anti-phase to each other, thereby counter-balancing each other and thereby linearizing an output signal V_MI (see fig. 4) of the microphone.

The pre-amplifier 6 can be realized by an active element Q1, which can be a transistor, such as an NPN bipolar junction transistor (BJT) configured in a common emitter voltage amplifying topology, as seen in fig. 1.

Fig. 1 further shows that the circuit topology may comprise of a resistor (RC) connected as load to a positive power supply (Vsupply). Two resistors (RB1 and RB2) are configured to establish a bias voltage for the base of the active element Q1 and a resistor (RE) acting as local feedback for the active element Q1. Combined with the DC-parameters of the active element Q1, the resistors RC, RB1, RB2 and RE may establish an operating point (q) for the active element Q1. The microphone capsule 4 may connect between RB1 and RB2 to the base of the active element Q1 and ground.

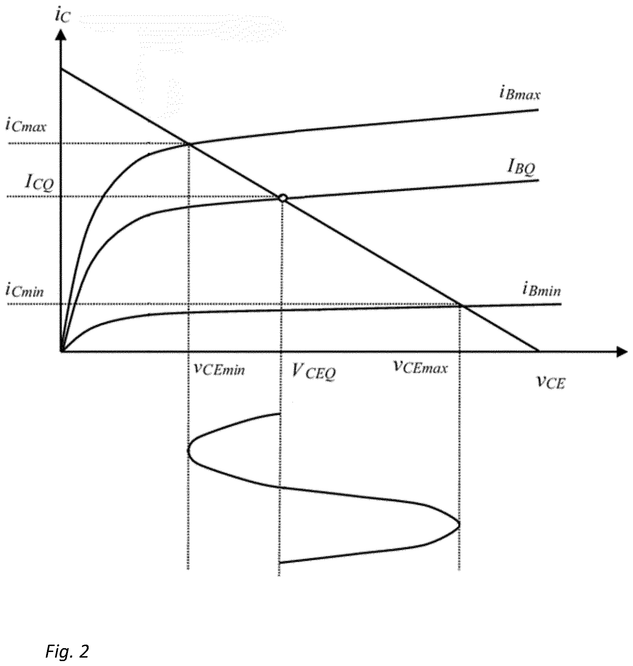

The active element Q1 may be a bipolar junction transistor, such as NPN BJT, which has, by its manufacturing processes and technology, several intrinsic nonlinearities build in. Relevant for this invention is the ohmic nonlinearity being the varying nature of symmetry in the current-voltage, I_{C}-V_{CE}, transfer characteristic for different current, I_{B} , see fig. 2.

Fig. 2 schematically illustrates an exemplary current-voltage, I_{C}-V_{CE}, transfer characteristic for different current, I_{B}. As mentioned above for fig. 1, the active element Q1 may be a bipolar junction transistor, such as NPN BJT, which has, by its manufacturing processes and technology, several intrinsic nonlinearities build in, and relevant for this invention is the ohmic nonlinearity being the varying nature of symmetry in the current-voltage, I_{C}-V_{CE}, transfer characteristic for different current, I_{B}.

Fig. 2 shows that for a given operating point (q) on a loadline (R_{L}), an equal positive (*i_{Bmax}*) and negative (*i_{Bmin}*) base current change will not yield an equal positive (*i_{Cmax}*) and negative *(i_{Cmin})* collector current change, resulting in a distorted output-voltage (V_PA) generated across the loadline (R_{L}).

Fig. 3 schematically illustrates an exemplary electrical circuit for a microphone. The microphone 2 is for capturing sound. The microphone 2 comprises a capsule 4 configured for receiving a sound input and converting the sound input into an output signal. The output signal comprising an output voltage V_CA. The output voltage V_CA has a first non-linearity at least at sound pressure levels (SPLs) above a first threshold.

The microphone 2 comprises a pre-amplifier 6 configured for receiving the output signal V_CA from the capsule and generating an output voltage V_PA. The output voltage V_PA has a second non-linearity for at least a first input signal level.

The microphone 2 is configured for providing that the capsule 4 and the pre-amplifier 6 generate similar amounts of the first non-linearity and of the second non-linearity, respectively, and that the first non-linearity and the second non-linearity are in anti-phase to each other, thereby counter-balancing each other and thereby linearizing an output signal V_MI (see fig. 4) of the microphone.

In fig. 3, the microphone capsule 4 is exemplified as an electret microphone capsule, which can be illustrated as a charged capacitor with a capacitance (C_{MIC}) that varies when the membrane is moving caused by a sound pressure level (SPL), creating a varying voltage V_CA to the SPL.

The electret microphone can be seen as a voltage generator in series with a capacitor. When connecting an electret microphone capsule 4 to the base of the active element Q1 of the common emitter voltage amplifying topology pre-amplifier 6, the varying voltage output V_CA generates a varying current (iᵢₙ) through the resistor Rᵢₙ of the pre-amplifier 6. A fraction of iᵢₙ is modulating the base current (I_{b}) of the active element Q1 related to the varying SPL.

Fig. 4 schematically illustrates an exemplary electrical circuit for a microphone. The microphone 2 is for capturing sound. The microphone 2 comprises a capsule 4 configured for receiving a sound input and converting the sound input into an output signal. The output signal comprising an output voltage V_CA. The output voltage V_CA has a first non-linearity at least at sound pressure levels (SPLs) above a first threshold.

The microphone 2 comprises a pre-amplifier 6 configured for receiving the output signal V_CA from the capsule and generating an output voltage V_PA. The output voltage V_PA has a second non-linearity for at least a first input signal level.

The microphone 2 is configured for providing that the capsule 4 and the pre-amplifier 6 generate similar amounts of the first non-linearity and of the second non-linearity, respectively, and that the first non-linearity and the second non-linearity are in anti-phase to each other, thereby counter-balancing each other and thereby linearizing an output signal V_MI (see fig. 4) of the microphone.

The microphone capsule 4 may for example be an electret microphone capsule, and it has from manufacturing build in non-linearities (nl_CA). This creates a non-linear output voltage V_CA compared to the sound pressure input. The pre-amplifier 6 has by topology also build in non-linearities (nl_PA).

Fig. 4 shows the system with non-linearities and feedback. The non-linear behavior of the microphone capsule 4 is in opposite phase of the non-linear behavior of the pre-amplifier 6 in this system.

By selecting a DC operating point (q) of the active element Q1, given by its transfer characteristics, the choice of loadline (R_{L}), the amount of local feedback (K), resulting in an equal non-linearity (nl_PA) of the pre-amplifier 6, but in opposite phase to the microphone capsule 6 non-linearity (nl_CA), will result in a cancellation of non-linearities that yields a very low total harmonic distortion (THD) figure of the system output (V_MI) up to the clipping point of the system.

As also shown in the fig. 4, the loop gain T = A*K*nl_PA, where, A is the gain or amplification of the active element Q1, and K is the local feedback.

The voltage output V_PA of the pre-amplifier 6 is thus the voltage output V_CA of the capsule multiplied by the loop gain T, i.e. V_PA = V_CA*T.

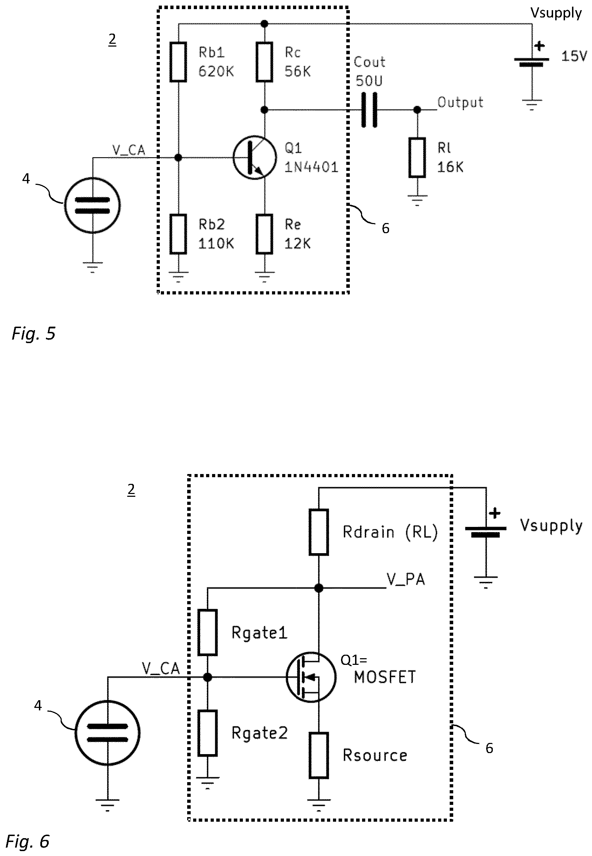

Fig. 5 schematically illustrates an exemplary electrical circuit for a microphone. The microphone 2 is for capturing sound. The microphone 2 comprises a capsule 4 configured for receiving a sound input and converting the sound input into an output signal. The output signal comprising an output voltage V_CA. The output voltage V_CA has a first non-linearity at least at sound pressure levels (SPLs) above a first threshold.

The microphone 2 comprises a pre-amplifier 6 configured for receiving the output signal V_CA from the capsule and generating an output voltage V_PA. The output voltage V_PA has a second non-linearity for at least a first input signal level.

The microphone 2 is configured for providing that the capsule 4 and the pre-amplifier 6 generate similar amounts of the first non-linearity and of the second non-linearity, respectively, and that the first non-linearity and the second non-linearity are in anti-phase to each other, thereby counter-balancing each other and thereby linearizing an output signal V_MI (see fig. 4) of the microphone.

In fig. 5, the microphone capsule 4 is exemplified as a condenser microphone capturing sound. The pre-amplifier 6 can be realized by an active element Q1, which can be a transistor, e.g. an NPN bipolar junction transistor (NPN-BJT), configured in a common emitter voltage amplifying topology.

Fig. 5 further shows that the circuit topology may comprise of a resistor (RC) connected to a positive power supply (Vsupply). Two resistors (RB1 and RB2) are configured to establish a bias voltage for the base of the active element Q1 and a resistor (RE) acting as local feedback for the active element Q1. Combined with the DC-parameters of the active element Q1, the resistors RC, RB1, RB2 and RE may establish an operating point (q) for the active element Q1. The microphone capsule 4 may connect between RB1 and RB2 to the base of the active element Q1 and ground.

Furthermore, between the active element Q1 and the resistor (RC), an output capacitor Cout is connected, and also a resistive load RL is connected before the Output.

In this fig. 5, also exemplary types, such as the active element Q1 being type 1N4401, and exemplary values for the different components are added, e.g the voltage supply Vsupp is 15V, the output capacitor Cout is 50U etc.

Fig. 6 schematically illustrates an exemplary electrical circuit for a microphone. The microphone 2 is for capturing sound. The microphone 2 comprises a capsule 4 configured for receiving a sound input and converting the sound input into an output signal. The output signal comprising an output voltage V_CA. The output voltage V_CA has a first non-linearity at least at sound pressure levels (SPLs) above a first threshold.

The microphone 2 comprises a pre-amplifier 6 configured for receiving the output signal V_CA from the capsule and generating an output voltage V_PA. The output voltage V_PA has a second non-linearity for at least a first input signal level.

The microphone 2 is configured for providing that the capsule 4 and the pre-amplifier 6 generate similar amounts of the first non-linearity and of the second non-linearity, respectively, and that the first non-linearity and the second non-linearity are in anti-phase to each other, thereby counter-balancing each other and thereby linearizing an output signal V_MI (see fig. 4) of the microphone.

In fig. 6, the microphone capsule 4 is exemplified as a condenser microphone capturing sound. The pre-amplifier 6 can be realized by an active element Q1, which can be a transistor, e.g. a metal-oxide-semiconductor field-effect transistor (MOSFET) configured in a common emitter voltage amplifying topology.

Fig. 6 further shows that the circuit topology may comprise of a resistor (Rdrain) connected as load RL to a positive power supply (Vsupply). Two resistors (Rgate1 and Rgate2) are configured to establish a bias voltage for the base of the active element Q1 and a resistor (Rsource) acting as local feedback for the active element Q1. Combined with the DC-parameters of the active element Q1, the resistors Rdrain, Rgate1, Rgate2 and Rsource may establish an operating point (q) for the active element Q1. The microphone capsule 4 may connect between Rgate1 and Rgate2 to the base of the active element Q1 and ground.

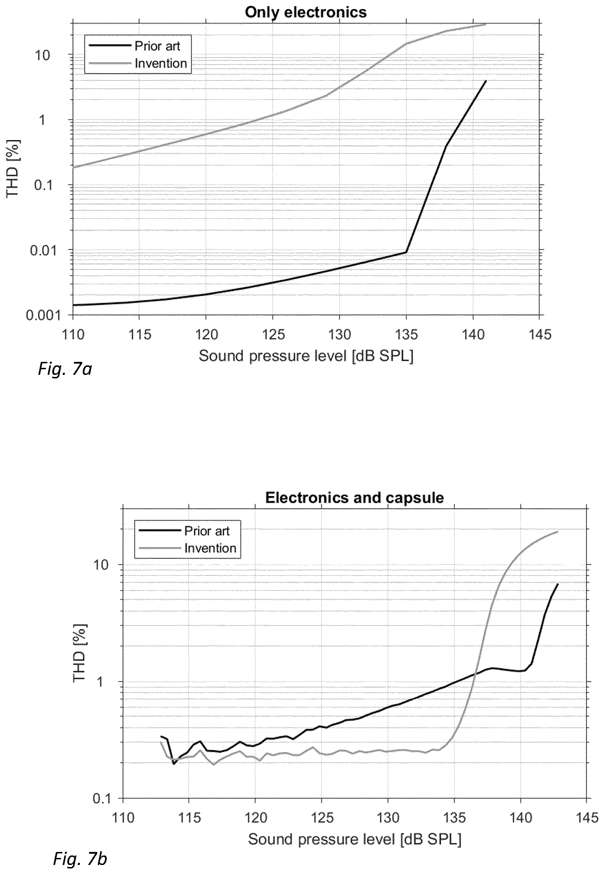

Fig. 7a and 7b schematically illustrate exemplary graphs showing the total harmonic distortion (THD) [%] as a function of sound pressure level [dB SPL]. The sound pressure levels in the graphs ranges from 110 dB SPL to 145 dB SPL.

The graphs shows that the THD performance of a microphone can change dramatically depending on the electrical properties of the preamplifier. The total harmonic distortion THD is a measure of distortion in non-linear systems where harmonic components (integer multiples of a fundamental frequency) are produced. THD is normally expressed as a percentage of the fundamental. The total harmonic distortion THD is a measure of how pure a signal is, and the percentage of the signal having unwanted distortion.

Fig. 7a shows the THD performance of the pre-amplifier electronics without considering the nonlinearities introduced by the capsule. The dark graph shows the prior art case. The bright graph shows the case of the present invention. It can be seen from the fig. 7a, that the prior art pre-amplifier electronics is extremely linear (dark graph). This is in contrast to the present invention, where the new pre-amplifier electronics is non-linear (bright graph).

In fig. 7a, the resulting THD is shown from 0.001% to 30%, and in fig. 7b and 7c the resulting THD is shown from 0.1% to 30%. The difference in dynamic range in the figures is due to the extreme linearity of the pre-amplifier used in the prior art.

Fig. 7b shows the THD performance of both the pre-amplifier electronics and the capsule when connected together. The dark graph shows the prior art case. The bright graph shows the case of the present invention. Fig. 7b shows that the THD is lower for the new pre-amplifier electronics and capsule than the prior art, for SPLs up to about 136 dB SPL, which is an advantage.

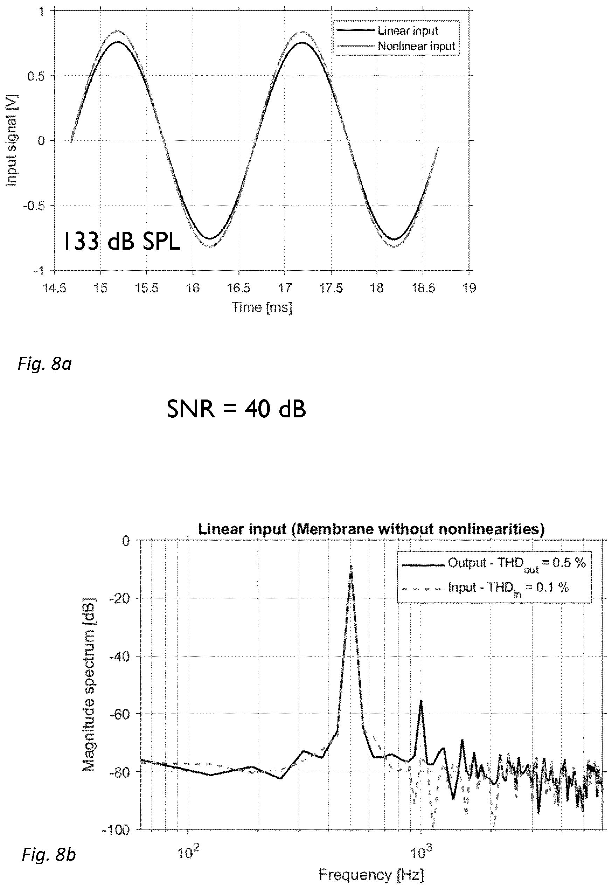

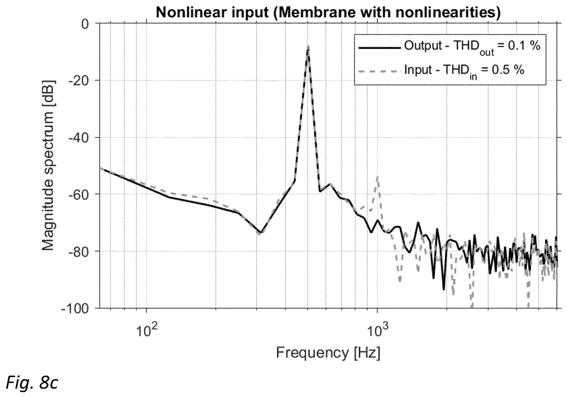

Fig. 8a, 8b and 8c schematically illustrate exemplary output of the pre-amplifier in two situations. The simulations are made with a 500 Hz pure tone. The sound pressure level is 133 dB SPL. The signal-to-noise ratio (SNR) is 40 dB.

Fig. 8a shows the input signal [V] as a function of time [ms]. The dark curve is with linear input. The bright curve is with non-linear input. It can be seen that at large sound pressure levels, e.g. 133 dB SPL, which is the case here, the electric field inside the capsule does not remain approximately constant, meaning that the membrane starts moving asymmetrically and creating larger oscillations that become more prominent when the membrane is moving towards the back electrode, generating an output voltage with larger positive voltages than negative ones.

Fig. 8a and 8b show magnitude spectrum [dB] as function of frequency [Hz].

Fig. 8b shows that for a linear input, which is a capsule membrane without non-linearities, when the input signal, bright dotted line, of the preamplifier is completely linear, i.e. without higher harmonics, then the electrical circuit of the preamplifier is generating distortion at the output, dark full line, in form of higher harmonics, in this case, mainly a second order harmonic, see at 1 kHz.

Fig. 8c shows that for a nonlinear input, which is a capsule membrane with non-linearities, when the input signal, bright dotted line, already contains nonlinearities, i.e. higher harmonics, for instance, due to the asymmetric motion of the membrane from the capsule at high sound pressure levels, then the electrical circuit of the preamplifier is counter-balancing those nonlinearities and thereby providing a linearized output signal, dark full line.

Note that the minimum value of THD that it is achievable in this simulation is 0.1% due to the presence of noise.

Although particular features have been shown and described, it will be understood that they are not intended to limit the claimed invention, and it will be made obvious to those skilled in the art that various changes and modifications may be made without departing from the scope of the claimed invention. The specification and drawings are, accordingly to be regarded in an illustrative rather than restrictive sense. The claimed invention is intended to cover all alternatives, modifications and equivalents.

### ITEMS:

1. A microphone for capturing sound, the microphone comprises:
   - a capsule configured for receiving a sound input and converting the sound input into an output signal, the output signal comprising an output voltage V_CA, the output voltage V_CA having a first non-linearity at least at sound pressure levels (SPLs) above a first threshold;
   - a pre-amplifier configured for receiving the output signal from the capsule and generating an output voltage V_PA, the output voltage V_PA having a second non-linearity for at least a first input signal level;
   wherein the microphone is configured for providing that the capsule and the pre-amplifier generate similar amounts of the first non-linearity and of the second non-linearity, respectively, and where the first non-linearity and the second non-linearity are in anti-phase to each other, thereby counter-balancing each other and thereby linearizing an output signal V_MI of the microphone.
2. The microphone of any of the preceding items, wherein the counter-balancing effect of the non-linearities between the capsule and the preamplifier is relevant for sound pressure levels (SPLs) above the first threshold, where the first threshold is high SPLs, and where the SPLs are between 110 dB SPL - 160 dB SPL.
3. The microphone of any of the preceding items, wherein the first input signal level comprises input signals with amplitudes above a second threshold.
4. The microphone of any of the preceding items, wherein the microphone is a condenser microphone or an electret microphone, and the capsule comprises a membrane and a back-electrode, or wherein the microphone is a dynamic microphone, and the capsule comprises a membrane and a magnet.
5. The microphone of any of the preceding items, wherein the microphone is connected to a power source, and wherein the power source is connected to a resistive load (RL).
6. The microphone of any of the preceding items, wherein the pre-amplifier comprises an active element Q1, and wherein the active element Q1 is a transistor, and wherein the transistor is a junction field-effect transistor (JFET) or a metal-oxide-semiconductor field-effect transistor (MOSFET) or a bipolar junction transistor (BJT), such as an NPN BJT.
7. The microphone of any of the preceding items, wherein the pre-amplifier comprises a bias circuit and a feedback circuit coupled together with the active element Q1.
8. The microphone of any of the preceding items, wherein the bias circuit is coupled between the capsule and the active element Q1 of the pre-amplifier.
9. The microphone of any of the preceding items, wherein the bias circuit and the feedback circuit of the pre-amplifier are adjusted for counter-balancing the first non-linearity of the capsule.
10. The microphone of any of the preceding items, wherein the resistive load (RL) is coupled to the pre-amplifier, and wherein the resistive load (RL) is coupled to the active element Q1 of the pre-amplifier.
11. The microphone of any of the preceding items, wherein the resistive load (RL) is coupled to the pre-amplifier via a feedback loop, the feedback loop comprising the feedback circuit of the pre-amplifier.
12. The microphone of any of the preceding items, wherein the active element Q1 of the pre-amplifier is connected to a resistor RC, where the resistor RC is connected to a positive power supply (Vsupp), and where a resistor RB1 and a resistor RB2 of the pre-amplifier are configured to establish a bias voltage for a base of the active element Q1 and a resistor RE acting as local feedback for the active element Q1.
13. The microphone of any of the preceding items, wherein the active element Q1 is configured for creating a distortion effect of the output voltage V_PA of the pre-amplifier thereby providing the second non-linearity.
14. The microphone of any of the preceding items, wherein the distortion effect caused by the active element Q1, provides that the output voltage V_PA of the pre-amplifier is different from what it would have been without the distortion effect, and wherein the distortion effect is more prominent for either positive voltages or negative voltages, thereby providing the second non-linearity.
15. The microphone of any of the preceding items, wherein the active element Q1 provides that the pre-amplifier provides the second non-linearity due to the resistive load (RL) introducing an amount of distortion.
16. The microphone of any of the preceding items, wherein the output voltage V_CA provided by the capsule has larger positive voltages than negative voltages or vice versa, thereby providing the first non-linearity.

### LIST OF REFERENCES

2 microphone
4 capsule
6 pre-amplifier
*V*_*CA* output voltage signal of capsule
*V_PA* output voltage signal of pre-amplifier
*V_MI* voltage output signal of microphone
*SPL* sound pressure level
*RL* resistive load
*JFET* junction field-effect transistor
*MOSFET* metal-oxide-semiconductor field-effect transistor
*BJT* bipolar junction transistor
*Q 1* active element
*RC* resistor
*V_{supply}* power supply
*RB1* resistor
*RB2* resistor
*RE* resistor
*Cmic* condensator mic capsule
*nl_CA* non-linearity of capsule
*nl_PA* non-linearity of pre-amplifier
*T* loop gain
*A* gain/amplification
*K* local feedback
*Cout* output capacitor
*Rgate 1* resistor
*Rgate2* resistor
*Rdrain* resistor
*Rsource* resistor
*THD* total harmonic distortion

## Claims

1. A microphone for capturing sound, the microphone comprises:
- a capsule configured for receiving a sound input and converting the sound input into an output signal, the output signal comprising an output voltage V_CA, the output voltage V_CA having a first non-linearity at least at sound pressure levels (SPLs) above a first threshold;
- a pre-amplifier configured for receiving the output signal from the capsule and generating an output voltage V_PA, the output voltage V_PA having a second non-linearity for at least a first input signal level;
wherein the microphone is configured for providing that the capsule and the pre-amplifier generate similar amounts of the first non-linearity and of the second non-linearity, respectively, and where the first non-linearity and the second non-linearity are in anti-phase to each other, thereby counter-balancing each other and thereby linearizing an output signal V_MI of the microphone.

2. The microphone of any of the preceding claims, wherein the counter-balancing effect of the non-linearities between the capsule and the preamplifier is relevant for sound pressure levels (SPLs) above the first threshold, where the first threshold is high SPLs, and where the SPLs are between 110 dB SPL - 160 dB SPL.

3. The microphone of any of the preceding claims, wherein the first input signal level comprises input signals with amplitudes above a second threshold.

4. The microphone of any of the preceding claims, wherein the microphone is a condenser microphone or an electret microphone, and the capsule comprises a membrane and a back-electrode, or wherein the microphone is a dynamic microphone, and the capsule comprises a membrane and a magnet.

5. The microphone of any of the preceding claims, wherein the microphone is connected to a power source, and wherein the power source is connected to a resistive load (RL).

6. The microphone of any of the preceding claims, wherein the pre-amplifier comprises an active element Q1, and wherein the active element Q1 is a transistor, and wherein the transistor is a junction field-effect transistor (JFET) or a metal-oxide-semiconductor field-effect transistor (MOSFET) or a bipolar junction transistor (BJT), such as an NPN BJT.

7. The microphone of any of the preceding claims, wherein the pre-amplifier comprises a bias circuit and a feedback circuit coupled together with the active element Q1.

8. The microphone of any of the preceding claims, wherein the bias circuit is coupled between the capsule and the active element Q1 of the pre-amplifier.

9. The microphone of any of the preceding claims, wherein the bias circuit and the feedback circuit of the pre-amplifier are adjusted for counter-balancing the first non-linearity of the capsule.

10. The microphone of any of the preceding claims, wherein the resistive load (RL) is coupled to the pre-amplifier, and wherein the resistive load (RL) is coupled to the active element Q1 of the pre-amplifier.

11. The microphone of any of the preceding claims, wherein the resistive load (RL) is coupled to the pre-amplifier via a feedback loop, the feedback loop comprising the feedback circuit of the pre-amplifier.

12. The microphone of any of the preceding claims, wherein the active element Q1 of the pre-amplifier is connected to a resistor RC, where the resistor RC is connected to a positive power supply (Vsupp), and where a resistor RB1 and a resistor RB2 of the pre-amplifier are configured to establish a bias voltage for a base of the active element Q1 and a resistor RE acting as local feedback for the active element Q1.

13. The microphone of any of the preceding claims, wherein the active element Q1 is configured for creating a distortion effect of the output voltage V_PA of the pre-amplifier thereby providing the second non-linearity, and/or wherein the distortion effect caused by the active element Q1, provides that the output voltage V_PA of the pre-amplifier is different from what it would have been without the distortion effect, and wherein the distortion effect is more prominent for either positive voltages or negative voltages, thereby providing the second non-linearity.

14. The microphone of any of the preceding claims, wherein the active element Q1 provides that the pre-amplifier provides the second non-linearity due to the resistive load (RL) introducing an amount of distortion.

15. The microphone of any of the preceding claims, wherein the output voltage V_CA provided by the capsule has larger positive voltages than negative voltages or vice versa, thereby providing the first non-linearity.
